# EUROPEAN PATENT APPLICATION

(11) **EP 0 622 839 A2**
(43) Date of publication of application: **02.11.1994**
(21) Application number: 94830204.7
(22) Date of filing: 29.04.1994
(51) Int. Cl.: H01L 21/603, H01B 1/20, H05K 3/32

(54) **Process for connecting an integrated circuit to an external circuit**

(30) Priority: 30.04.1993 IT RM930273
(71) Applicant: CONSORZIO EAGLE, I-67051 Avezzano (AQ) (IT)
(72) Inventor: Amideo, Pasquale, Consorzio Eagle, I-67051 Avezzano (AQ) (IT); Musilli, Carlo, Consorzio Eagle, I-67051 Avezzano (AQ) (IT); Salvati, Roberto, Consorzio Eagle, I-67051 Avezzano (AQ) (IT)
(74) Representative: Iannone, Carlo Luigi

(57) **Abstract**

The invention concerns a process for connecting an integrated circuit to an external circuit comprising the steps of:
· aligning the integrated circuit with respect to the external circuit;
· providing a layer of anisotropic material between the integrated circuit and the external circuit; and
· connecting by thermocompression said integrated circuit to said external circuit.

## Description

The present invention concerns a process for connecting an integrated circuit to an external circuit.

More particularly, the invention is included between the microelectronics technologies concerning the packaging of integrated circuits, and still more precisely in the kind of products so-called "consumer products".

As it is well known, the VLSI circuits are realized integrating hundred thousands of elementary components connected each other in a silicon plate.

The development occurred in the recent years allows to continuously increase the number of components for unitary area of silicon.

This fact involves the realization of always more little and complex silicon chips, and consequently an always higher number of connections with the external circuit.

It is also known that in order to realize such a connections two kinds of problems must be faced and solved: the reduction of the density of the connections from the silicon level to the connection pad level of the printed circuit and the protection of the chip against mechanical shocks and environmental attacks.

The above problems have been faced up and solved until now by the package encapsulating the chip.

In fact, the package realizes a protection of the chip, bringing its electrical connections to a density compatible with the printed circuit, being at the same time realized in such a way that it can be used with the standard fabrication techniques employed in this field (e.g. welding process employing tin/lead alloys melting at about 200°C).

Generally speaking, the introduction of the package, although solves the above mentioned problems, involves a remarkable increasing of costs, dimensions and weight of the device obtained, and requires the adoption of particular precautions when it is subjected to high thermal gradients and/or extreme temperatures typical of certain welding processes.

In other words, a reduction of the efficiency of the chip and a limitation of its potentialities are present.

Among the different packaging technologies, the one providing the use of plastic packages can be mentioned.

This kind of package requires the use of a lead-frame sustaining the chip and creating the external contacts of the package, of the wires connecting the chip to the lead-frame, of the plastic resins encasing the connection and giving the desired shape to the package, the adoption of processes like the deposition and the hardening of the alloy fixing the chip to the lead-frame, the welding of the connecting wires, the pressing of the resin to shape the package, the shearing of the terminals (lead frame) and their bending to make them suitable for welding.

All the above involves, other than the realization of the packages only partially water-proof and sensitive to the thermal gradients and to the high temperatures, an increase of costs ranging from 20% to 35% and of the volume and of the weight from 30 to 100 times.

In case of high reliability devices, requiring features of resistance to the temperature and to the humidity, ceramic packages are realized.

They determine an increase of the cost higher than 50%, of the weight from 100 to 200 times and of the volume from 30 to 100 times.

Among the known technologies, the TAB (Tape Automated connecting) is included, said technology requiring the realization of bumps by cumulating metallic material (gold, copper, Tin-lead alloy (solder)) on the welding connection pads upon which the protective metalizations are placed.

Terminals are then welded by heat compression or eutectic welding on a film upon which the copper circuit lined with tin or gold is laminated.

Among the known connection techniques it can also be mentioned the one known as COB (Chip On Board), said technique providing that the welding and connection processes are directly made of the circuit substrate, thus being necessary to fulfil determined thermal and finishing features. The printed circuit cannot have big dimensions since the dimensions of the machines must be respected to reduce costs.

This technology is competitive as far as costs and dimensions are concerned, but it can be used only in particular cases in view of the specific requisites.

More recently, the techniques of direct connection have been introduced, among which the one according to the present invention is included, aid techniques allowing to reduce the interconnection levels during the execution of the process.

Always among the direct connection techniques it is included the technology known as C4. It is a technology developed by IBM, providing the deposition on the integrated circuit preferably of microspheres in correspondence of the connecting connection pads and the consequent re-melting of the same after that the connection pads of the chip have been aligned with those corresponding on the connecting circuit.

Also the technology known as COG (Chip On Glass), concerning numerous techniques of connection on glass, is included within this group. First, a gold or copper bump must be realized by thin film, photolithografic technique and galvanic growing, one bump corresponding to each connection pad of the chip, before making the cut of the single chip from the wafer.

Then a metalization of the connection pads is realized on Indium-Tin oxide (ITO), that would be an insulating and transparent film present on the glass substrates and not suited to be welded by pastes like Tin-Lead paste, etc.

All these techniques more or less require a working on the chip o substrate.

By the re-melting of the welding paste applied before aligning the two parts, or by a thermocompression, or by a different technology, the connection is made. It can also be possible to use, in some cases, anisotropic glues with a polymeric base, conferring a conductivity only along the Z axis, in place of the welding pastes, making also in this case the connection by compression.

In the context of the above mentioned techniques, it is evidenced a basic aspect that has determined the scarce diffusion of the direct connection, that is the necessity of growing the bumps or of providing welding alloy on the connection pads of the chip.

Such a necessity, apart from the additional costs, involves a limitation for the practical application, since the same manufacturer of the integrated circuit must perform such an operation.

Moreover, in many cases it is necessary a final operation to realize the insulation of the assembled piece with respect to the surrounding environment.

The solution proposed according to the present invention overcomes the above mentioned drawbacks, thus being a valid alternative to the standard packaging techniques, reducing at the same time costs and noticeably simplifying the processes.

Substantially, the solution proposed according to the present invention allows to reduce the cost of the final device, simplifying, as already stated in the above, the package and the related processes; to reduce weight and dimensions of the assembled device; to use a welding process to be realized with a very lower temperature with respect to the temperature used for the tin/lead welding.

The solution proposed according to the invention is based on the utilization of an anisotropic material, such as a thermoplastic or thermosetting adhesive, in the form of a film or a paste, charged with conductive microspheres, randomly dispersed in the polymeric matrix.

It is therefore a specific object of the present invention a process for connecting an integrated circuit to an external circuit comprising the steps of:
· aligning the integrated circuit with respect to the external circuit;
· providing a layer of anisotropic material between the integrated circuit and the external circuit; and
· connecting by thermocompression said integrated circuit to said external circuit.

Particularly, according to the invention, said external circuit can be realized above a flexible material, polyimide or polyester or above a rigid material, e.g. glass, epoxy resins with fiber glass, phenolic resins with cellulose, etc.

According to the invention, said anisotropic material is a thermoplastic and/or thermosetting adhesive having inside plastic particles covered with metallic cover (Ni, Au, etc.) random dispersed. Particularly, said adhesive will be a polymeric adhesive, preferably a thermosetting adhesive, taking into consideration that with a material having a curing temperature higher better performances are obtained.

The density of the particles dispersed in the anisotropic material varies with the kind of support, being lower with a flexible support and higher with a rigid support.

A higher density of the particles involves, with the same connecting area, a lower value of contact resistance, higher reliability of the connection, bearing always in mind that a reduction of the insulation between adjacent contacts could occur.

The layer of anisotropic material can be comprised of a film or of a paste layer.

The present invention will be now described, in an illustrative but not limitative way, according to its preferred embodiments, with particular reference to the figures of the enclosed drawings, wherein:
figure 1 is an exploded view of an example of utilization of the process according to the invention;
figures 2a and 2d show section views of the principle of the process according to the present invention;
figure 3 shows an application of a process according to the prior art; and
figure 4 shows the application of a further example of the process according to the present invention to be compared with the application of figure 3.

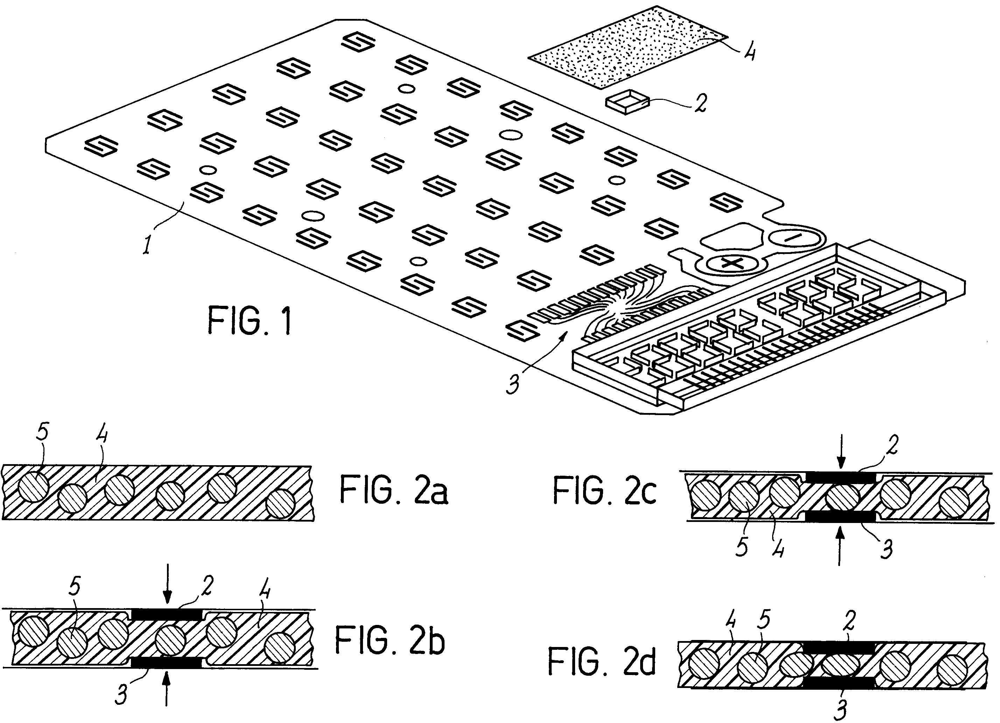

In figure 1 it is shown a substrate of external circuit 1, that can be one of the various kind obtainable by the already known technologies, upon which an integrated circuit must be coupled.

The integrated circuit 2 is of the standard type, not being necessary metalizations or the realization of bumps.

Said integrated circuit in the example shown in figure 1 must be connected to a part 3 of the circuit 1 realized on a flexible support, that is provided for the purpose of accommodating the connection density of the integrated circuit 2 with that of the logic circuit 1.

As already mentioned, said circuit 1 can also be realized employing rigid material, for example glass.

In the present example, the conductive tracks of the circuit 3 are realized by copper.

Between the integrated circuit 2 and the part 3 of the circuit 1, a layer 4 of anisotropic material is disposed, said layer comprising a binder made up of a thermosetting resin laminated in such a way to realize a film inside which metallic particles are dispersed in a random, but checked, way.

Figure 2a provides a schematic view of the layer 4.

When the two parts to be connected, i.e. the integrated circuit 2 and the support circuit 3, are pressed one against the other with the interposition of the layer 4 (figure 2b), by a heated bar, the thermosetting matrix of the layer 4 softens and the metallic parts 5 contacts the conductors to be connected.

An electric connection is obtained only along the axis corresponding to the direction of the pressure exerted (figure 2c) and the metallic particles 5 remain insulated one from the other.

Upon termination of the welding process, the metallic particles assure the necessary electric contact, while the thermosetting matrix assure the mechanical features of the connection (figure 2d).

The Applicant has further realized a prototype of a calculator employing a rigid glass support.

According to the standard technique, the calculator was realized employing:
· a liquid crystal display;
· a rigid printed circuit having only one face;
· an integrated circuit with a plastic package;
· a flexible printed circuit for the keyboard;
· an elastomer having the duty of allowing the pressure connection between the flexible printed circuit and the rigid printed circuit.

Employing the technology according to the present invention, the obtained prototype is composed as follows:
· a liquid crystal display, slightly bigger, upon which the connection circuit for the printed ITO circuit has been direct realized;
· the bare integrated circuit;
· the flexible printed circuit for the keyboard;
· an elastomer for pressure connecting the flexible printed circuit for the keyboard and the display.

From the above, it cant be put into evidence how the reduction of the parts necessary to assemble the calculator is remarkable, and further that in order to solve the problem arising from the connection of the ITO circuit on the glass with the printed circuit, normally requiring a double level connection, according to the invention it has been possible to operate on a single level.

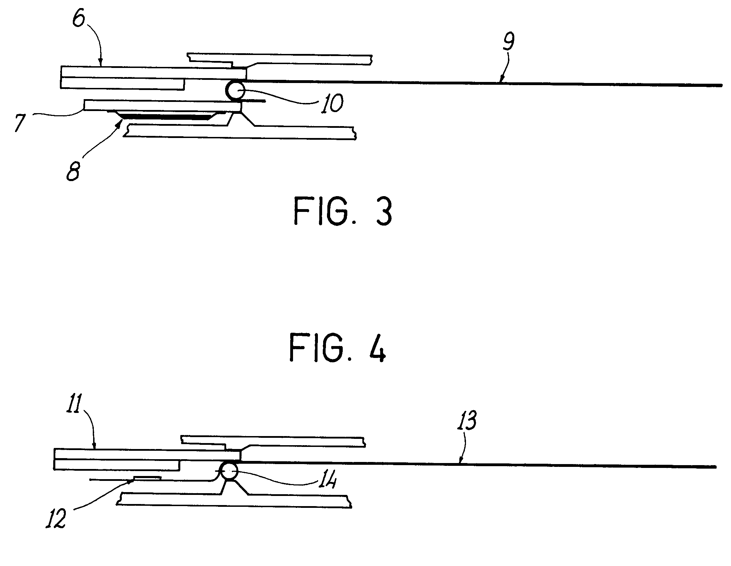

Another prototype realized on the basis of the above technology is that shown in figure 4, and concerns a calculator on a flexible substrate to be compared with figure 3 in order to appreciate the differences and the results obtained.

Particularly, comparing the two technologies, with the standard technique of figure 3, it can be noted how the standard calculator comprised:
· a liquid display crystal 6;
· a rigid printed circuit with a single face 7;
· an integrated circuit with plastic package 8;
· a flexible printed circuit 9 for the keyboard;
· an elastomer 10 that allows the connection of the flexible printed circuit with the rigid circuit.

Instead, using the technology according to the invention, the prototype of figure 4 is so realized:
· a liquid crystal display 11;
· a bare integrated circuit 12;
· a flexible printed circuit 13 working as keyboard and support for the chip;
· an elastomer 14 having the duty to allow the connection of the flexible printed circuit with the rigid circuit.

Once more, advantages deriving from the utilization of the technique according to the invention must be put into evidence, i.e. the utilization of printed circuits without any further operation, no treatment of the ITO provided on the substrate, global reduction of the steps of the connection process.

Further, measures have been made in order to determine the electric behaviour of the connection. Capacity and inductance values have been determined in function of the frequency of the signals applied.

In this way, the total impedance value specific of the kind of connection has been obtained.

The frequencies used were between 10 KHz and 10 MHz.

From the results obtained, is it demonstrated that the performances of the innovative connection are comparable under an electric point of view with those relevant to the TAB assembling technique and are better than those obtained with a plastic package.

The present invention has been disclosed in an illustrative, but not limitative way, according to its preferred embodiments, but it is to be understood the changes and/or modification can be introduced by those skilled in the art without departing from the relevant scope, as defined by the enclosed claims.

## Claims

1. Process for connecting an integrated circuit to an external circuit characterized from the fact of comprising the steps of:
· aligning the integrated circuit with respect to the external circuit;
· providing a layer of anisotropic material between the integrated circuit and the external circuit; and
· connecting by thermocompression said integrated circuit to said external circuit.

2. Process according to claim 1, characterized in that said external circuit is realized above a flexible material

3. Process according to claim 2, characterized in that said flexible material is polyimide or polyester.

4. Process according to claim 1, characterized in that said external circuit is realized above a rigid material.

5. Process according to claim 4, characterized in that said rigid material is glass, epoxy resins with fiber glass or phenolic resin with cellulose.

6. Process according to one of the preceding claims, characterized in that said anisotropic material is a thermoplastic and/or thermosetting adhesive having inside plastic particles covered with metallic cover (Ni, Au, etc.) random dispersed.

7. Process according to claim 6, characterized in that said adhesive is a polymeric adhesive.

8. Process according to claim 6 or 7, characterized in that said adhesive is a thermosetting adhesive.

9. Process according to one of the preceding claims, characterized in that the density of the particles dispersed in the anisotropic material varies with the kind of support, being lower with a flexible support and higher with a rigid support.

10. Process for connecting an integrated circuit to an external circuit according to each one of the preceding claims, substantially as illustrated and described.
